# EUROPEAN PATENT SPECIFICATION

(11) **EP 1 204 542 B1**
(45) Date of publication and mention of the grant of the patent: **26.11.2003**
(21) Application number: 00948176.3
(22) Date of filing: 28.07.2000
(51) Int. Cl.: B60Q 1/48

(54) **CAPACITIVE SENSOR**
KAPAZITIVER SENSOR
CAPTEUR DE CAPACITE

(30) Priority: 29.07.1999 GB 9917817; 22.10.1999 GB 9925124; 20.04.2000 GB 0009930
(43) Date of publication of application: 15.05.2002
(73) Proprietor: AB Automotive Electronics Ltd., Cardiff CF4 7YS (GB)
(72) Inventor: MOON, Anthony, Llandaff, Cardiff CF5 2QH (GB)
(74) Representative: Midgley, Jonathan Lee
(86) International application number: GB0002902
(87) International publication number: WO01008925

(56) References cited:
- GB-A- 2 266 397
- US-A- 4 887 066
- US-A- 5 394 292
- PATENT ABSTRACTS OF JAPAN vol. 1999, no. 13, 30 novembre 1999 (1999-11-30) & JP 11 235961 A (AISIN SEIKI CO LTD), 31 août 1999 (1999-08-31)

## Description

The present invention relates to a capacitive sensor in particular for attachment to a vehicle for sensing the proximity of the vehicle to other objects, for example to assist when manoeuvring such a vehicle.

In recent years a number of luxury cars have been fitted with sensors particularly on the rear of the vehicle to warn the driver of objects. In this way when the vehicle is being reversed, a collision with unseen or obscured objects can be avoided whilst still being able to position the vehicle close to such objects, e.g. walls, bollards etc.

However, such sensors are complicated and expensive and consequently they tend not to be commercially viable for lower cost cars. In addition, these systems usually require unsightly sensors to be mounted on the bumper of the car.

US-5,394,292 describes a proximity sensor according the preamble of claim 1.

Therefore, according to the present invention there is provided a proximity sensor for a vehicle comprising: an innermost guard plate; a generally elongate outermost sensor plate; and calculation means for providing proximity information based upon the capacitance between the sensor plate and electrical ground, wherein the shape of the sensor plate varies along its length to provide increased sensitivity portions.

In a preferred embodiment, the plates are mounted on a vehicle bumper. This allows the plates to be mounted in close proximity to provide a strong output signal. In order to avoid being damaged, both plates are preferably mounted on the inside of the bumper whilst being separated by an insulator. The guard plate is used to shield the sensor plate to ensure that it only detects changes in the outwards direction, i.e. away from the vehicle. The plates preferably extend substantially along the entire length of the bumper including any portion passing around the comer of the vehicle. The sensor and guard plates are preferably provided as elongate strips extending along the length of the bumper. Furthermore, the guard plate is preferably wider than the sensing plate, ideally three to four times wider.

Because of the varying shape of the profile of the rear of the vehicle, the guard and/or sensor plate are preferably non-uniform in shape. In particular, the sensor plate preferably increases in width towards the ends. This provides increased sensitivity at the edges of the vehicle. With a uniform strip the sensitivity may be reduced at the edges because the obstruction can only couple capacitively with one side of the sensor, whereas an object directly behind the middle of the vehicle will couple capacitively with both sides of the sensor. Whilst the shape of the sensor plate is ideally tailored to the shape of the vehicle for each application, the sensing plate may have a simpler generic shape to provide improved sensitivity on all vehicles. For example, the sensing plate may comprise a central portion having uniform width with two end portions or stubs of larger width on each end. Alternatively, the sensing plate may have a central portion of uniform width with two end portions having progressively increasing widths.

Other objects may be mounted on the bumper of a vehicle which may be made of metal of have a metallic component. In this case, whilst this has a substantially constant effect on the capacitance, it may reduce the sensitivity of the sensor to objects immediately out from the bumper. For example, many vehicles have a number or licence plate mounted on the bumper. These are made of metal or incorporate a metal film to make it reflective. This can reduce the sensitivity of the sensor to objects immediately beyond the number plate. This can give a poor range profile. For example, when the car approaches a stake sticking vertically out of the ground, the range of sensitivity will typically be less if the nearest point to the car is the number plate. This can be overcome by making the sensor wider (i.e. of greater area) immediately behind the number plate or other obstructing object. The metal in the number plate couples capacitively to the sensor and acts as a sensor itself.

The sensors of the present invention are primarily intended to be mounted on the rear of a vehicle to assist a driver when reversing. However, the sensors are also suitable for front or even side mounting, e.g. for avoiding collisions with objects at low-level which are obscured from view below the bonnet. Additionally, when a vehicle is manoeuvring, either forwards or backwards, there is a danger that the side wings may strike an object if the vehicle is turning at the same time. For example, if a vehicle is reversing and turning, for example into a parking space, the driver will generally be looking towards the rear of the vehicle and his attention may not be on the front of the vehicle which may swing out and collide with an obstruction. A front or side mounted sensor could be provided to detect such objects near the wings particularly in front of the front wheels. Such a facility may be provided by a single sensor on the front and sides of the vehicle or two or more separate sensors connected to a single sensing circuit or with their own individual sensing circuits. Where a single sensing circuit is used, the circuit may be arranged such that the two sensors simply act as a single sensor formed in two parts or alternatively, the circuit may use a multiplexor to separately monitor the two sensors sequentially. Similarly, the sensors at the front and rear may be combined and a single sensor used to detect all the sensor plates on the car.

Different materials have different effects on the output of a capacitive sensor. For example people, concrete, wood, metal, stone and plants provide a strong output from the sensor whereas other objects can give weaker responses, in particular low mass insulating objects such as plastics. This may be problematic in view of the likelihood of encountering plastic objects such as cones when manoeuvring a vehicle. However, whilst objects of different materials provide different outputs, the relationship between the output from the sensor and the distance between the sensor and an object follows a similar formula (the sensor output increases as a power of the distance between the sensor and the object) for any object. By monitoring the speed of the vehicle it is possible to calculate the rate of change of the output from the sensor with distance from that object. Thus it is possible to obtain an indication of the range to the object which has been detected that is independent of the magnitude of the output signal from the sensor and thus use this to provide a more accurate indication of the distance between the object and the sensor irrespective of the material of the object being detected.

Therefore, in accordance with second aspect of the present invention there is provided a proximity sensor including means for determining the speed of the vehicle and wherein the calculation means is adapted to utilise this speed information along with the rate of change of the output to provide more accurate proximity information.

Although the sensor is sensitive to the presence of the surface over which the vehicle is travelling, because this normally has a constant effect, its effect on the determination of the distance to other objects can be cancelled out. However, where the vehicle is travelling over uneven ground then clearly the variation in the height of the sensor above the ground will give the appearance to the sensor that the ground is moving away or towards it. Furthermore, because most vehicles are supported on a 'springy' suspension, as the vehicle accelerates and decelerates, the vehicle tilts forward and backwards causing the front and rear of the vehicle to rise or fall relative to the ground. This can have the effect of appearing to the sensor that the ground is moving away from or towards it. This tilting of the vehicle can lead to the sensor providing incorrect or varying information about the distance to an object. A similar effect can occur when the vehicle travels over objects such as metal drains or manhole covers that have good conductance to ground. These effects can be minimised by reducing the sensitivity of the sensor. However, this means that the effective range at which an object can be detected is also reduced.

Therefore, according to a third aspect of the present invention, the proximity sensor is provided with a second sensor for providing information about the ground clearance or ride height. This information can be used to correct the output from the main sensor allowing the sensitivity of the sensor to be maintained.

Whilst the second sensor is preferably a capacitive sensor arranged in a downward facing configuration, this is not essential and any manner of sensor which is capable of providing information about the height of the main sensor above the ground is adequate. Capacitive sensors are particularly preferable for detecting the presence of objects such as manhole covers which are substantially flush with the ground but, like a change in height, are likely to effect the main capacitive sensor.

In addition to the above, where the vehicle is moving towards a slope, the main sensor which is sensitive to the height of the road in distance away from the vehicle may be affected by an approaching slope before the ride height sensor, which is not yet over the incline of the slope, has detected any change in height. It is therefore preferable to orient the second sensor such that instead of facing directly downwards, it is arranged to point, or detect the height, slightly outwards of the vehicle to provide an indication of a change in the slope of the ground over which the vehicle is travelling sooner so as to correspond more closely with the detection range of the main sensor.

According to a fourth aspect of the present invention, the sensitivity of the sensor to the height of the sensor above ground can also be reduced by modifying the shape of the sensor to provide a further shield plate which is positioned below the sensor plate in order to reduce the sensitivity of the sensor plate to the ground below it. This shield plate may be connected to the guard plate or even an extension thereof.

The shield plate may be provided by a small section of a conducting object lying beneath the sensor to reduce the sensitivity of the sensor directly downwards. However, the shield plate may extend for some distance around and even above the sensor in order to more effectively shield the sensor from detecting in undesirable regions. The shield plate may be connected to the guard plate or to ground. This can either be done with an ohmic contact, i.e. with a physical connection, or capacitively, for example where the shield plate is provided on one side of a bumper and it is preferable to provide the connection to the guard plate from the other side of the bumper.

The sensitivity of the sensor to ground effects may also be modified by modifying the shape of the sensor plate such that the lower part of the sensor plate is further outward of the vehicle then the upper part.

As indicated above, the plates may be formed by simply providing electrically conducting strips across the rear (or front, or side) of a vehicle. However, as a further feature, it is becoming more common when painting vehicle bumpers to use electrically conductive paint for at least some of the coatings (e.g. the primer). This allows an electric charge to be put on the bumper in order to attract the paint towards the bumper electrostatically. This saves paint and gives an improved coating, particularly at the edges. This conductivity of the paint can be used in the present invention to provide one or more of the plates of the sensor.

In a preferable construction, the sensor and guard plates would still be mounted behind the bumper but the conducting paint surface of a bumper is capacitively coupled to the sensor. Preferably a section of the surface of the bumper is left non-conducting either by not painting it at all or painting it with a non-conducting paint. In this way, a "window" is provided through which the sensor plate can "see". Thus the conductive paint surface of the bumper can be used as a shield plate which when connected to the guard plate or ground shields the sensor from detecting the surface below the vehicle and thus avoids effects of variations in the height and material of the surface over which the vehicle is passing.

Most modem bumpers comprise an outer shell of hard plastic with an interior filled at least partially with packing material for absorbing the energy of any impact, e.g. a high density foam material such as polypropylene foam. These bumpers are intended to withstand low speed collisions without any permanent damage apparent on the outside. However, even low speed impacts may damage sensor strips if they are placed between the shell of the bumper and the foam material. It may therefore be preferable to mount the sensor strips within or behind the foam filler to minimise the effect of any impact and reduce any damage to the sensor strips.

There will now be described a specific embodiment of the present invention with reference to the accompanying drawings in which:
Figure 1 shows the range of sensitivity of a sensor having uniform guard and sensor plates;
Figure 2 shows the range of an ideal sensor profile;
Figure 3a shows a sensor having uniform width sensor plates respectively;
Figures 3b to 3f show examples of sensors having non-uniform sensor plates;
Figure 4 shows a graph of sensor output against distance to a target;
Figure 5 shows a schematic view of a vehicle fitted with a secondary sensor;
Figure 6 shows a modified sensor including a shield plate;
Figures 7A and 7B show two alternative arrangements of the construction shown in figure 6;
Figure 8A shows a cross-section through a conventional vehicle bumper;
Figure 8B shows a cross-section through a vehicle bumper such as that in figure 8A with a sensor according to the present invention included therein;
Figures 9A and 9B show cross-sections through a vehicle bumper with two alternative sensor cross-section shapes;
Figure 10 shows an construction in which a conductive coating is utilised; and
Figure 11 shows a further modification of the present invention.

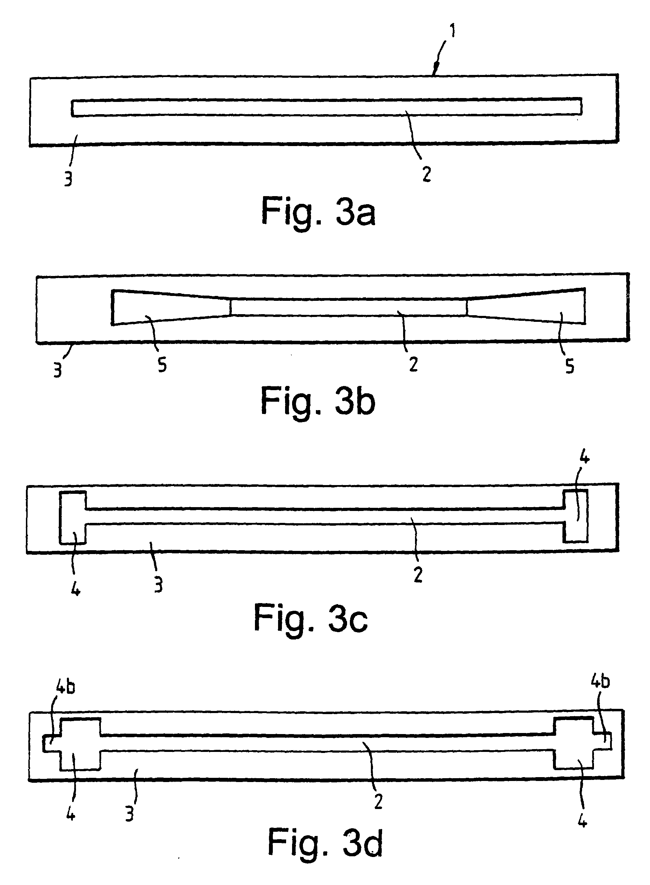

According to a first embodiment of the invention, a sensor 1 consists of two strips of metal, or other conductive material, insulated from each other and provided on the inside of the bumper 6 of a vehicle 10. The two strips of metal form the guard plate 3 and the sensor plate 2 of the sensor. The plate which is outermost relative to the vehicle is called the sensor plate and the plate which is innermost i.e. closest to the vehicle itself, is the called the guard plate. Figures 3a, 3b and 3c show examples of the arrangement of the guard and sensor plates relative to each other. Although the sensor plates are shown as being flat in Figures 3a, 3b and 3c, in use the laminated sensors would be fitted to the profile of the inside of the bumper 6 (which may not be flat) of the vehicle to which they were attached.

The sensor plate 2 would be typically around 25 mm wide whilst the guard plate 3 is typically three to four times the width of the sensor plate, as shown in Figure 3a. Where the sensor plate has a non-uniform width, the relative widths of the guard and sensor plate vary along their lengths with the sensor plate being relatively wider at the ends than in the middle.

In use, the guard and sensor plates are connected to a control unit (not shown). The control unit supplies high frequency signals to the sensing and guard plates. Objects in the vicinity of the vehicle present a capacitance to ground. In fact this capacitance is formed by two capacitances in series, namely a capacitance between the sensor plate and the object in series with a capacitance between the object and ground. The control unit measures this capacitance between the sensor plate and ground. The unit may be triggered automatically when reverse gear is engaged (for a rear mounted system), manually or otherwise. When the unit is triggered, an initial capacitance measurement is made. As the distance between the vehicle and an object changes, the capacitance changes. The measured capacitance provides an indication of the distance between any objects in close proximity to the vehicle and the sensor plate, and hence the rear of the vehicle. The control unit senses the change in capacitance and uses this to provide the driver of the vehicle with an indication of the distance to the object. This indication can be provided in any number of ways. For example the control unit can be arranged to provide different tones depending on the range to a target. A broken tone could be output when the object is for example 80 cm away, then as the target moves closer, at about 50 cm the tone could become faster, and finally at a close range of about 30 cm the tone could change to a continuous tone to signal the driver to stop reversing.

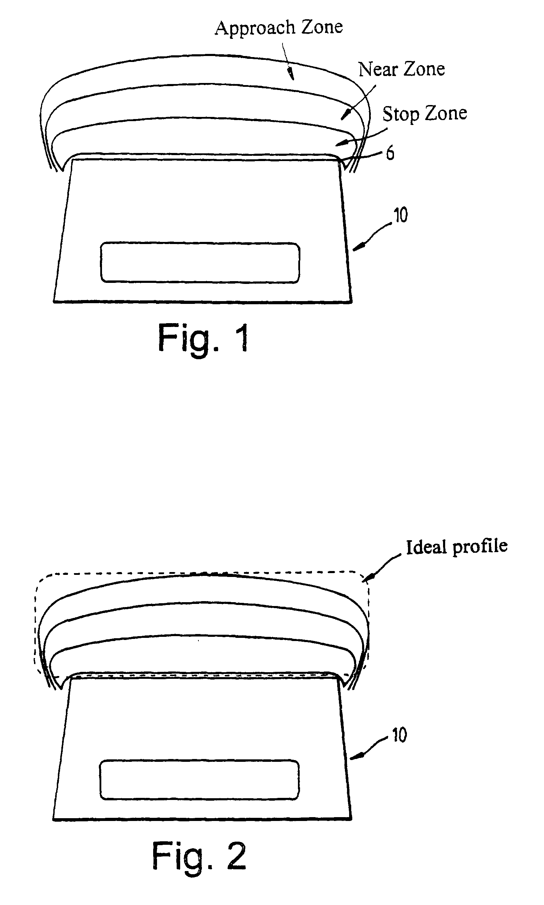

Figure 1 shows an example of the relative ranges of three zones of sensitivity: an approach zone; a near zone and a stop zone. In Figure 1, the sensing plate and guard plate have uniform widths as shown in Figure 3a. It will be apparent from Figure 1 that as the vehicle moves towards an object, the respective position of the object across the width of the vehicle would affect the distance from the vehicle at which it is sensed. For example, if the vehicle is reversing towards a bollard which is located along the centre line of the vehicle then the bollard will be detected earlier than if the bollard was located at the extreme left or right of the vehicle. This is applicable in all three of the detection zones.

Figure 2 shows an ideal profile for the sensing areas. A sensor having this profile would detect objects at given distances regardless of their relative position across the width of the car. The sensor of the present invention aims to achieve such an ideal profile by increasing the sensitivity at the ends of the sensor and/or reducing the sensitivity in the centre of the sensor. This is achieved in the present invention by varying the shape of the sensor plate. Rather than using a sensor plate with uniform width, a sensor plate which is wider at the ends than in the middle is used.

In order to approximate the sensor profile as closely as possible to the ideal profile shown in Figure 2, the width of the sensor plate should be varied to correspond to the shape and orientation of the vehicle bumper. However, this would require separate sensors to be made for every different shape of vehicle and vehicle bumper. However, considerable improvements in the sensor profile can be made by providing a sensor plate which has a central portion having a substantially uniform width along the central part of the bumper with the ends of the sensor plate having an increased width to provide improved sensitivity at the ends of the bumper corresponding to the edge of the vehicle.

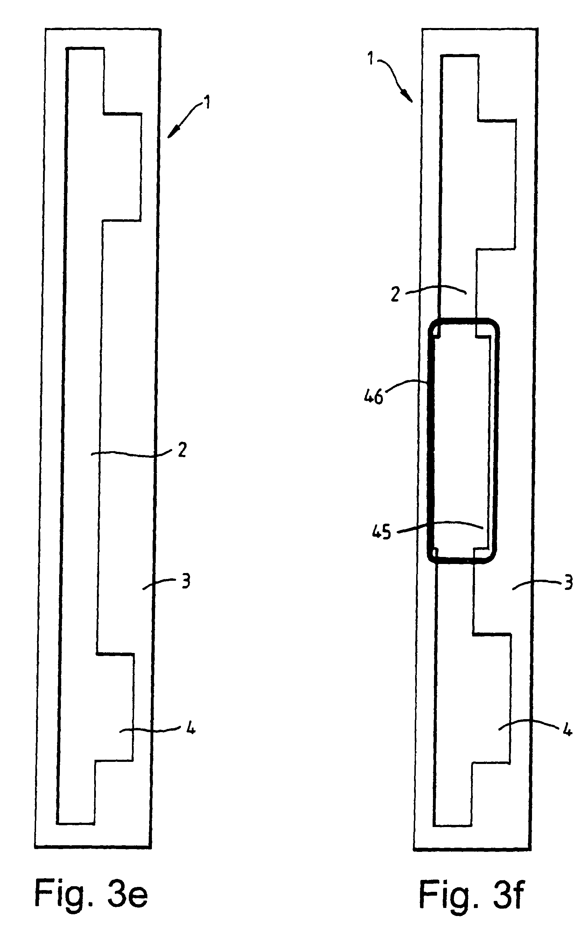

The sensor plate may have a profile as shown in Figure 3b having sections 5 where the width is progressively increased towards the end of the bumper or alternatively, the sensor plate may have a central portion of uniform width and two end portions of larger widths as shown in Figure 3c. Here small sections 4, or stubs, of increased width added to the ends of the sensor plate. Figure 3d shows a modified version of the sensor plate shown in Figure 3c. This arrangement has a stub of increased width located slightly in from the ends of the sensor plate, leaving a narrow section 4b at the end of the sensor plate. This shape provides the improved sensitivity around the comer of the vehicle, an even response to obstructions behind/in front of the vehicle whilst rejecting obstructions to either side of the car which would not get in the way when the vehicle is moving forwards or backwards. For example, when a car is reversing into a space between two other cars such as in a car park, it is inconvenient for the sensor to trigger because of the parked cars on either side. Thus the arrangements shown in Figure 3d and 3e provide improved sensitivity at the comers of the vehicle without providing unnecessary sensitivity to objects at the side of the vehicle which will not obstruct the passage of the vehicle. The portion with increased width near but slightly in from the ends provides increased sensitivity at the comers.

Many bumpers have items such as number plates, trim, lights etc. on them which, if they are metallic may affect the sensitivity of the sensor around a localised part of the bumper. Number plates are often made of metal or include a metallic reflecting layer in them to improve the visibility of the plate in poor light. However, the presence of metallic material can reduce the sensitivity of the sensor and thus affect the uniformity of the detection range of the sensor immediately out from the number plate. However, this can be overcome by enlarging the width of the sensor plate in the region 45 behind the number plate 46. The metal in the number plate couples capacitively to the sensor and acts as a part of the sensor itself. The arrangement shown in Figure 3f shows an example of a modified sensor plate.

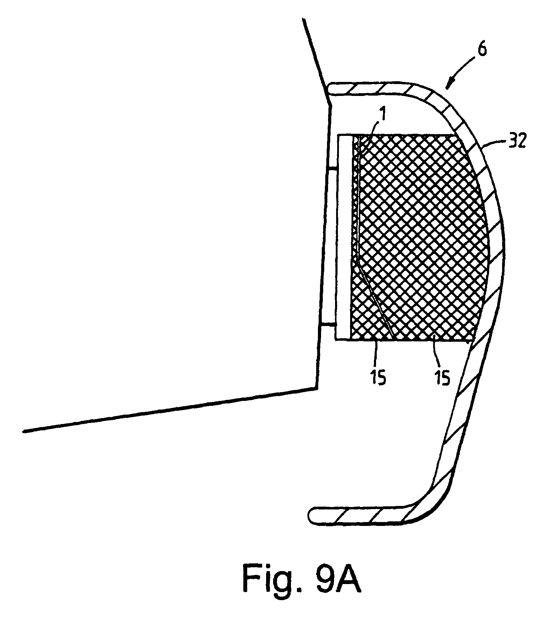

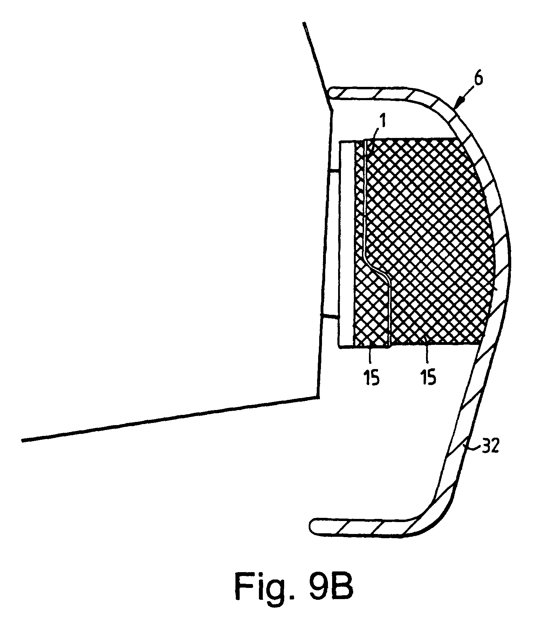

The sensor and guard plates are provided on the inner surface of the outer edge of the bumper so that the plates are protected from being damaged but are still as close to the rear of the vehicle as possible. However, the plates may be formed within the bumper. To protect the sensor and guard plates, they may be placed in or behind the foam or similar packing material 15 of the bumper. Figures 9A and 9B show examples of constructions where the sensor and guard plates are mounted within the packaging material.

A capacitive sensor according to the present invention, will detect any object that possesses sufficient mass, especially objects which are even slightly conducting. Thus objects such as concrete, wood, metal, stone and organic materials such people, animals, plants or trees are detected without difficulty. However objects which have low mass and which are insulating such as plastic materials like cones provide a poor response.

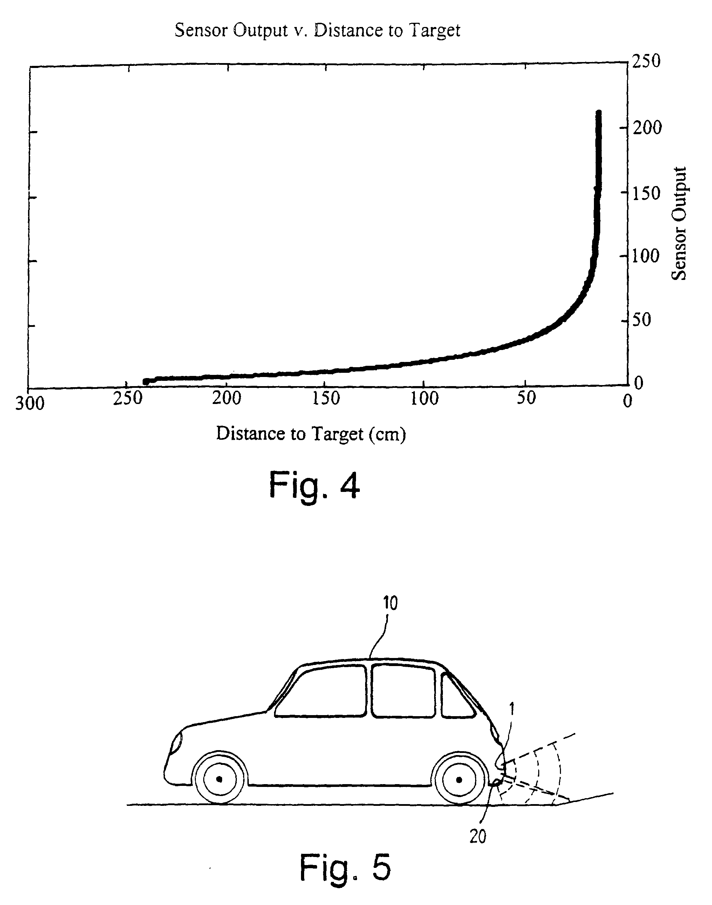

Figure 4 shows a graph providing an indication of the sort of output which is provided by the sensor for an object which is a given distance away. Figure 4 in particular represents the response due to a 2.5cm diameter metal pole at various distances from the sensor. It is apparent from Figure 4 that the response provided by the sensor has an exponential shape. Whilst the sensitivity and amplitude of the output varies from object to object, the underlying shape of the response curve is substantially the same for all objects.

In a practical implementation, as the voltage output from the sensor increases above pre-set thresholds, the driver of the vehicle is provided with different types of warnings, for example at ranges of 80, 50 and 30 cm. However, low mass or insulating objects give a much lower output from the sensor and the warning that would normally be triggered at 80cm for most other conducting objects may not be given until the object is as little as 40cm away. Clearly this provides a very narrow margin from which the sensor moves from indicating the maximum range to the minimum range which is correspondingly reduced. Furthermore, this provides an inconsistent indication of the range to an object. It is inconvenient if the driver becomes accustomed to the first warning being provided at a range of 80cm to suddenly be faced with the warning only coming on at 40cm which may result in the driver not bringing the vehicle to a halt quickly enough.

As the general shape of the response curve of the sensor is known and by monitoring the change in the output from the sensor as the vehicle moves towards an object, it is possible to determine from the rate of change of the sensor output and the speed of the vehicle where on the curve the sensor output lies and whether the object is of a material which would provide a strong output or one which would provide a weak output. This may be done simply by monitoring the output from the sensor and examining the magnitude of the output and the rate of change of the output and if the output, although weak, is rising rapidly with distance, the sensor can determine that the object is much closer to the vehicle than a "typical" object. The sensor can then trigger the alert appropriate to the range of the object from the vehicle. This may be simply to provide the mid-range warning instead of the far range warning or to actively recalibrate the sensor output responsive to the properties of the detected object to provide an accurate output of the distance to the object.

Where a vehicle is travelling over rough ground the height of the sensor above the ground will vary. Similarly whilst the vehicle is manoeuvring, the change in speed caused by braking or accelerating has a tendency to cause the vehicle to tilt forward or backwards due to the vehicle being mounted on a sprung suspension. Consequently, particularly if the braking or acceleration is hard, the ends of the vehicle will move up or down appreciably, again causing the height of the sensor above the ground to vary. Whilst the presence of the surface over which the vehicle is travelling has an effect on the sensor, as long as the height of the sensor above the surface remains constant this will have a constant effect and thus the effect of the surface can be ignored. However, when the height of the sensor above the ground varies due to acceleration/deceleration of the vehicle, then the effect of the ground on the sensor will vary significantly. This can cause the sensor to believe that there is an object closer to, or further away from, the vehicle than in fact there is and this can trigger a false warning. Whilst this can be overcome by reducing the sensitivity of the sensor, this clearly reduces the effective range on which the sensor can be usefully used.

In order to overcome this problem, in a second embodiment of the invention, a second sensor 20 is fitted to the vehicle to provide an indication of the height of the main sensor above the ground and to compensate for any changes in height.

This second sensor 20 may be a capacitive sensor similar to the main sensor 1. In this way, the second sensor 20 gives an output that is related to the ground clearance by subtracting its output from the output of the main, outward facing sensor. The effect of changes in ground clearance are thus eliminated. In this way sensitivity of the main sensor 1 can be maintained allowing objects to be detected at a longer range.

Whilst it is convenient to provide the second sensor 20 as a capacitive sensor, effectively acting as a reference, it is also possible to utilise any other kind of height indicating sensor which can be appropriately calibrated to provide an output to compensate for changes in the height of the vehicle detected by the main sensor. For example, a vehicle which is already fitted with a ride-height sensor can be modified to provide an output from that height sensor to the sensor of the present invention.

Whilst the above modification provides compensation for changes in the height of the ground over which the vehicle is travelling directly below the sensor, in practice the vehicle may be manoeuvring over flat ground towards a sloping surface or uneven ground, e.g. a curb. Under these circumstances, the main outward facing sensor would detect the change in height before the height sensor and consequently would be misled into believing there was an object close to it and may trigger a false alarm.

Consequently in a further modification of the present invention the secondary sensor is arranged to point slightly outwards of the vehicle as well as down. This can be seen in Figure 5 where the secondary sensor 20 detects the height of the ground outwards of the vehicle rather than underneath the very back of the vehicle. In this way, the secondary sensor 20 can provide a more accurate indication of the height of the main sensor 1 relative to the ground which the main sensor is detecting. This in turn provides a more accurate correction for the variation in the height of the ground over which the sensor is detecting.

According to a third embodiment of the present invention, a further modification of the sensor is provided. Instead of using a secondary sensor to detect the height of the main sensor above the ground, the main sensor may be modified to reduce the sensitivity in the region immediately below the sensor and possibly also slightly outward of the vehicle. This is achieved by providing a shield plate 7 mounted below the sensor plate to reduce the sensitivity of the sensor in the region underneath the sensor. In effect, the shield plate 7 prevents the sensor "seeing" the ground below it and thus it is blind or at least insensitive to any changes in height off the ground.

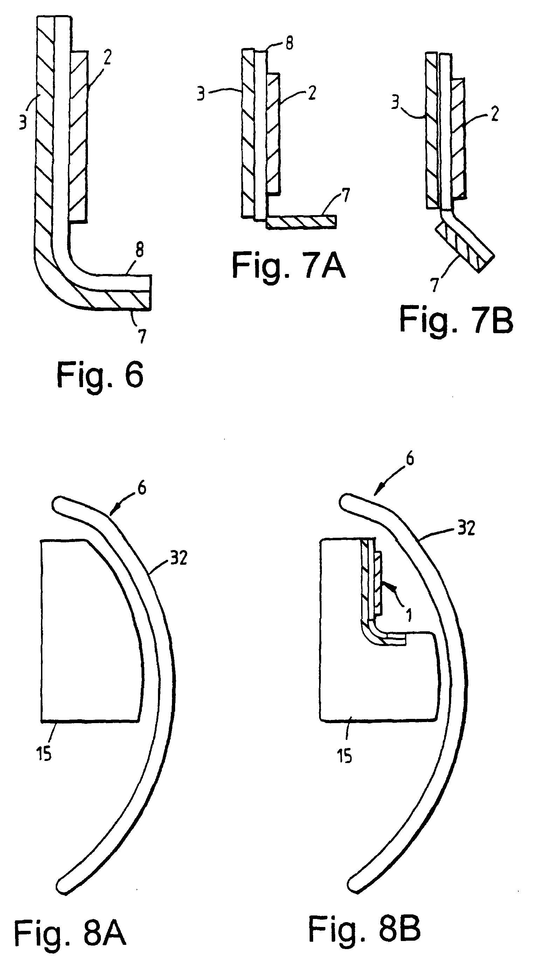

Figure 6 shows schematically how the sensor according to the first embodiment would be modified. In this embodiment, the guard plate is simply extended down and around underneath the sensor plate to act as the shield plate 7. Figures 7A and 7B show two alternative variations on this. In Figure 7A, the shield plate 7 is a separate plate provided below the sensor which is then electrically connected to the guard plate. As shown in Figure 7A this may be by a physical wire connection but may also be provided by a capacitive connection to the guard plate. Whilst Figure 6 and 7A show the shield plate 7 being arranged substantially perpendicular to the main part of the guard plate and sensor plate, this is not essential. As shown in Figure 7B, the shield plate 7 may be arranged at an angle to adjust how much shielding is provided and what region around the sensor is shielded. This allows the sensor to be modified according to differing requirements and different implementations. For example, when the sensor is used in different vehicles or in different positions on the same vehicle, the region which the shield plate 7 is required to shield will vary according to the height at which the sensor is positioned and the relative location of the sensor.

As indicated above, the shield plate 7 is connected to the guard plate. However, it is also possible to connect the shield to the ground e.g. by connecting it to the car body, or to any fixed DC potential. This would have a similar effect to connecting it to the guard plate. In the example shown, the shield plate 7 is located in close proximity to the sensor. However, in a practical implementation, it may be more convenient to position the shield plate 7 further away from the guard sensor plate or it may be inconvenient to provide a direct connection between the guard plate and shield plate 7. Thus in some implementations it may be more convenient to connect the shield to the ground or even use an existing part of the vehicle to which the sensor is attached to act as a shield.

Figure 8B shows an example of the present invention installed in a vehicle bumper. As can be seen from the comparison between Figure 8A and Figure 8B, no modification of the outward appearance of the bumper is required. Instead, the sensor may simply be embedded in the shock absorbing foam 15 provided within more modem bumpers. In the construction shown in Figure 8B, a portion of the foam 15 has been removed and the sensor has been embedded therein. However, assuming the energy absorbing foam 15 is not significantly conducting, then the sensor could be formed so that it is completely enclosed within the foam thus minimising any reduction in the amount of foam present.

Figures 9A and 9B show two further examples of how the sensors may be embedded in the packing material (shock absorbing material) of the bumper. These two embodiments further show how the sensor profile can be modified to reduce the sensitivity of the sensor to objects below the vehicle. By angling the lower part of the sensor forward or having the lower part set forward with an interconnecting portion, the sensitivity of the sensor to irrelevant objects such as the ground is reduced.
Furthermore, by embedding the sensor in the bumper, it is protected from damage which may be caused by incidental knocks and low speed collisions.

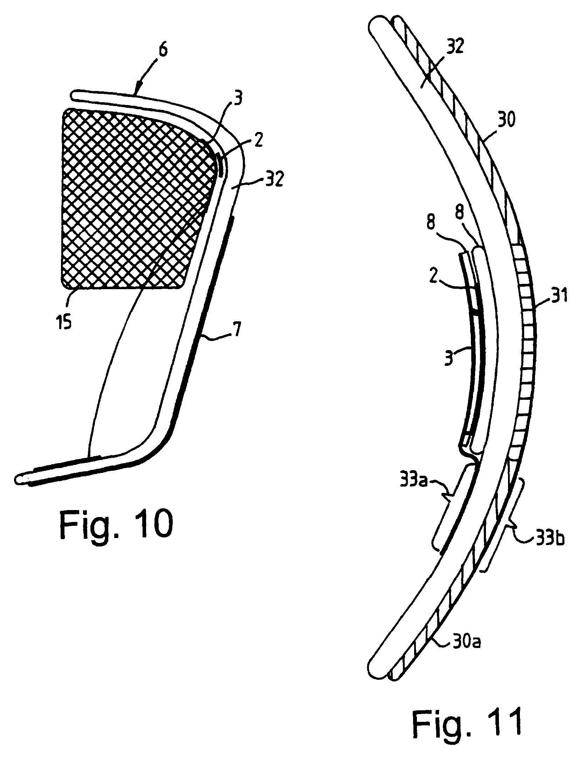

Figure 10 shows a practical embodiment of sensor incorporated in a bumper utilising a conducting surface provided on the bumper as part of the painting process.

Figure 10 shows a sensor with a guard and sensor plate arranged substantially as described above. However, rather than providing a separate plate to act as a shield, the surface of the bumper is provided with a conducting surface. Many bumpers are now coated with electrically conductive paint for at least some of the coatings applied to it. In particular, an electrically conductive primer coating may be provided. In this way, by putting an electrical charge on the bumper, the paint can be attracted to it electrostatically which saves paint and gives a better coating, especially at the edges.

Therefore, by providing a conducting surface as shown in Figure 10, which lie beneath and also slightly in front of the sensor plate, the surface can be used to act as a shield plate 7. As described above, the shield plate 7 may be connected to the guard plate or directly to ground. Such a connection can be easily provided at any point on the surface of the bumper.
However, from a practical point of view, it may be inconvenient or relatively expensive to provide a physical electrical connection to the outside surface of a bumper. Therefore, it may be preferable to provide a connection to the conducting surface of the bumper using a capacitive connection. This can be achieved by providing a conductive surface or plate on the inner surface of the bumper which is then electrically connected to the guard plate or ground. The skin 32 of the bumper is relatively thin and generally made of an electrically insulating material. This allows a capacitor to be formed providing good capacitive connection through the skin 32 of the bumper. In this way, forming a connection on the inner surface of the bumper avoids the need for electrical connections through or around the outside of the bumper skin 32. Also limitations on the appearance and arrangement of connections are less crucial than if they were normally visible on the outer surface of the bumper.

Whilst it is preferable to provide a conducting surface on the bumper which does not cover the entire surface of the bumper skin 32 this would not prevent the sensor from working. If a conducting surface was extended across the entire surface of the bumper skin 32, this would include a portion in front of the sensor plate. This increases the overall sensitivity of the sensor by making the conductive surface acts as a sensor plate. However, the rejection of ground effects is not as good.

To overcome this, a small 'window' can be provided in the conducting surface directly in front of the sensor allowing the bumper skin 32 to be almost completely coated with a conducting surface. This 'window' would allow the sensor to maintain its sensitivity directly outward of the vehicle i.e. in the region directly behind (or directly in front of, respectively) the vehicle whilst providing the beneficial reduction in sensitivity below the sensor. Such a window may be provided by masking off a portion of the bumper skin 32 when a conducting surface is being applied or by removing some of the conducting surface after being applied to the entirety of the bumper skin 32.

Figure 11 shows a further embodiment of the present invention. In this construction, a conductive coating 30,30a is provided on the bumper skin 32 above 30a and below 30 the sensor with a non-conducting coating 31 or no coating being provided in-between. Figure 11 shows a non-conducting coating 31. In the construction in Figure 11, the arrangement of guard and sensor plates is similar to the other constructions show above. However, in this construction the guard plate is extended and bent down and underneath the sensor plate to reduce the sensitivity of the sensor below the sensor. The guard plate is then further extended and bent to run along the inside surface of the bumper skin 32 to provide a capacitive coupling to the conducting surface of the bumper skin 32 to act as a shield plate 7. This capacitive coupling is formed where the extended guard plate and the conductive coating 30 overlap 33a, 33b. This allows the sensor to be formed very simply by providing a single guard plate arranged to be attached to the bumper skin 32 with a sensor plate sandwiched between the guard plate and bumper skin 32 with insulators 8 in between. This arrangement provides a very flexible system which can be arranged to be connected to a large array of different bumper designs without being limited to specific bumper designs. The guard plate may be simply formed of a flexible conducting sheet such as a sheet of metal foil having an adhesive surface on one side which allows the sensor to be adhered to the bumper skin 32 and to the sensor plate and insulating spaces sandwich.

Whilst the present invention has been described in respect of a rear mounted bumper, it will be appreciated that the sensor may be applied to any part of the vehicle including the sides, front or even the roof, for example to protect against vehicles colliding with low roofs, bridges etc. Additional sensors, including ground and sensor plates, could be provided at appropriate locations to protect these different parts of a vehicle. These additional sensors may be provided with separate sensor circuitry to provide a separate indication of a hazard. However, some or all of the sensors may be sensed using a single circuit, either by mutiplexing the signal from each sensor in turn or by simply sensing all the sensors together to provide an overall warning of hazardous objects which the vehicle may be approaching.

## Claims

1. A proximity sensor (1) for a vehicle comprising:
an innermost guard plate (3);
a generally elongate outermost sensor plate (2); and
calculation means for providing proximity information based upon the capacitance between the sensor plate and electrical ground, **characterized in that** the shape of the sensor plate varies along its length to provide increased sensitivity portions.

2. A sensor according to claim 1 wherein the guard plate and sensor plate are arranged close to each other.

3. A sensor according to claim 1 or 2, wherein, in use, the guard plate is arranged to be between the sensor plate and the vehicle (10).

4. A sensor according to claim 1, 2 or 3, wherein the sensor plate has a non-uniform width along its length.

5. A sensor according to any one of the preceding claims, wherein the sensor plate has a portion (4, 5) at each end having a larger width than the portion in the middle.

6. A sensor according to any one of the preceding claims, wherein the width of the sensor plate at a given point along the length of the sensor plate is chosen according to the shape and orientation of a bumper (6) to which the sensor is to be attached, in use.

7. A sensor according to any one of the preceding claims, wherein the central part of the sensor plate has a substantially uniform width with end sections (4, 5) having at least a portion having a larger width.

8. A sensor according to claim 7 wherein the width of the end sections (5) of the sensor plate progressively increase towards the ends.

9. A sensor according to claim 7 wherein the width of the end sections (4) is uniform.

10. A sensor according to claim 7 wherein the end sections comprise a first part (4) having a width larger than the middle part and a second outermost part (4b) having a width less than the first part.

11. A sensor according to any one of the preceding claims wherein the guard plate is an elongate strip.

12. A sensor according to claim 10 wherein the guard plate has a width which is larger at the ends.

13. A sensor according to any one of the preceding claims wherein the width of the guard plate at a given point is selected according to the shape and orientation of the bumper to which it is to be attached in use.

14. A sensor according to any of the preceding claims wherein the calculation means determines the proximity information based upon the speed of the vehicle, the determined capacitance and the rate of change of the determined capacitance.

15. A sensor according to any of the preceding claims further comprising a second sensor (20) for providing a compensating signal representative of the height of the sensor above the ground and wherein the calculation means is adapted to correct the proximity information using the compensating signal.

16. A sensor according to claim 15 wherein the second sensor (20) is a capacitive sensor.

17. A sensor according to claims 15 or 16 wherein the second sensor (20) is arranged to detect the height of the sensor above the ground outward of the vehicle.

18. A sensor according to any one of the preceding claims further comprising a shield plate (7).

19. A sensor according to claim 18 wherein the shield plate (7) is connected to the guard plate (2).

20. A sensor according to claim 18 wherein the shield plate (2) is connected to electrical ground.

21. A sensor according to claim 19 or 20 wherein the shield plate (7) is connected capacitively.

22. A sensor according to any one of claims 18 to 21 wherein the shield plate is arranged below the sensor plate.

23. A sensor according to any one of claims 18 to 22 wherein the shield plate is formed as an electrically conductive coating on the surface of an object to which the sensor is attached.

24. A sensor according to claim 23 wherein the conductive coating is a paint.

25. A vehicle bumper (6) having a sensor (1) according to any one of the preceding claims attached thereto.

26. A vehicle bumper according to claim 25 wherein the guard plate (3) and the sensor plate (2) are mounted, in use, on the innermost side of the bumper.

27. A vehicle bumper according to claims 25 or 26 wherein the guard plate and the sensor plate extend substantially along the full length of the bumper.

28. A vehicle bumper according to claims 25, 26 or 27 wherein the sensor plate has one or more portions (4, 5) of increased width along its length corresponding to obstructions on the bumper outward of the sensor plate.

29. A vehicle bumper according to any one of claims 25 to 28 wherein the guard plate and the sensor plate are encased at least partially within the shock absorbing material (15) of the bumper.

30. A vehicle bumper according to any one of claims 25 to 28 wherein the guard plate and the sensor plate are behind the shock absorbing material (15) of the bumper.

31. A vehicle bumper according to any one of claims 25 to 30 when dependent on claim 15 wherein the second sensor (20) is mounted on the bumper.

32. A vehicle (10) having one or more sensors according to any one of claims 1 to 24 or one or more vehicle bumpers according to any one of claims 25 to 31 attached thereto.

## Patentansprüche

1. Näherungssensor (1) für ein Fahrzeug, umfassend:
eine innerste Schutzplatte (3);
eine im Allgemeinen längliche äußerste Sensorplatte (2) und
Berechnungsmittel zur Bereitstellung der Abstandsinformation, basierend auf der Kapazität zwischen der Sensorplatte und der elektrischen Masse, **dadurch gekennzeichnet, dass** die Form der Sensorplatte entlang ihrer Länge variiert, um Abschnitte mit höherer Empfindlichkeit bereitzustellen.

2. Sensor nach Anspruch 1, wobei die Schutzplatte und die Sensorplatte nahe zueinander angeordnet sind.

3. Sensor nach Anspruch 1 oder 2, wobei, im Einsatz, die Schutzplatte zwischen der Sensorplatte und dem Fahrzeug (10) anzuordnen ist.

4. Sensor nach Anspruch 1, 2 oder 3, wobei die Sensorplatte eine nicht konstante Breite entlang ihrer Länge aufweist.

5. Sensor nach einem der vorhergehenden Ansprüche, wobei die Sensorplatte einen Abschnitt (4, 5) an jedem Ende aufweist, dessen Breite größer ist als die des Abschnitts in der Mitte.

6. Sensor nach einem der vorhergehenden Ansprüche, wobei die Breite der Sensorplatte an einem bestimmten Punkt entlang der Länge der Sensorplatte nach der Form und Ausrichtung eines Stoßfängers (6) gewählt wird, an dem, im Einsatz, der Sensor anzubringen ist.

7. Sensor nach einem der vorhergehenden Ansprüche, wobei der Mittelteil der Sensorplatte eine im Wesentlichen konstante Breite mit Endabschnitten (4, 5) aufweist, die mindestens einen Abschnitt mit einer größeren Breite haben.

8. Sensor nach Anspruch 7, wobei die Breite der Endabschnitte (5) der Sensorplatte zu den Enden hin stetig zunimmt.

9. Sensor nach Anspruch 7, wobei die Breite der Endabschnitte (4) konstant ist.

10. Sensor nach Anspruch 7, wobei die Endabschnitte einen ersten Teil (4), dessen Breite größer ist als die des mittleren Teils und einen zweiten äußersten Teil (4b) umfassen, dessen Breite kleiner ist als die des ersten Teils.

11. Sensor nach einem der vorhergehenden Ansprüche, wobei die Schutzplatte ein länglicher Streifen ist.

12. Sensor nach Anspruch 10, wobei die Schutzplatte eine Breite aufweist, die an den Enden größer ist.

13. Sensor nach einem der vorhergehenden Ansprüche, wobei die Breite der Schutzplatte an einem bestimmten Punkt nach der Form und Ausrichtung des Stoßfängers ausgewählt wird, an dem sie im Einsatz anzubringen ist.

14. Sensor nach einem der vorhergehenden Ansprüche, wobei die Berechnungsmittel die Abstandsinformation, basierend auf der Geschwindigkeit des Fahrzeuges, der ermittelten Kapazität und der Änderungsgeschwindigkeit der ermittelten Kapazität, ermitteln.

15. Sensor nach einem der vorhergehenden Ansprüche, der außerdem einen zweiten Sensor (20) zur Bereitstellung eines für die Höhe repräsentativen Kompensationssignals des Sensors über dem Boden umfasst und wobei die Berechnungsmittel so ausgelegt sind, dass die Abstandsinformation unter Verwendung des Kompensationssignals korrigiert wird.

16. Sensor nach Anspruch 15, wobei der zweite Sensor (20) ein kapazitiver Sensor ist.

17. Sensor nach Anspruch 15 oder 16, wobei der zweite Sensor (20) so angeordnet ist, dass die Höhe des Sensors über dem Boden vom Fahrzeug weg erfasst wird.

18. Sensor nach einem der vorhergehenden Ansprüche, wobei dieser außerdem eine Abschirmplatte (7) umfasst.

19. Sensor nach Anspruch 18, wobei die Abschirmplatte (7) mit der Schutzplatte (2) verbunden ist.

20. Sensor nach Anspruch 18, wobei die Abschirmplatte (7) mit der elektrischen Masse verbunden ist.

21. Sensor nach Anspruch 19 oder 20, wobei der Anschluss der Abschirmplatte (7) durch kapazitive Kopplung erfolgt.

22. Sensor nach einem der vorhergehenden Ansprüche 18 bis 21, wobei die Abschirmplatte unterhalb der Sensorplatte angeordnet ist.

23. Sensor nach einem der vorhergehenden Ansprüche 18 bis 22, wobei die Abschirmplatte als elektrisch leitfähige Beschichtung auf der Oberfläche eines Gegenstandes ausgebildet ist, an dem Sensor angebracht ist.

24. Sensor nach Anspruch 23, wobei die leitfähige Beschichtung ein Lack ist.

25. Fahrzeugstoßfänger (6), der einen daran angebrachten Sensor (1) nach einem der vorhergehenden Ansprüche aufweist.

26. Fahrzeugstoßfänger nach Anspruch 25, wobei die Schutzplatte (3) und die Sensorplatte (2), im Einsatz, auf der innersten Seitenfläche des Stoßfängers angebracht werden.

27. Fahrzeugstoßfänger nach Anspruch 25 oder 26, wobei die Schutzplatte und die Sensorplatte sich im Wesentlichen entlang der Gesamtlänge des Stoßfängers erstrecken.

28. Fahrzeugstoßfänger nach Anspruch 25, 26 oder 27, wobei die Sensorplatte einen oder mehrere Abschnitte (4, 5) mit zunehmender Breite entlang der Länge aufweist, gemäß Hindernissen am Stoßfänger im Außenbereich der Sensorplatte.

29. Fahrzeugstoßfänger nach einem der Ansprüche 25 bis 28, wobei die Schutzplatte und die Sensorplatte mindestens teilweise im Stoßdämpfungsmaterial (15) des Stoßfängers gekapselt sind.

30. Fahrzeugstoßfänger nach einem der Ansprüche 25 bis 28, wobei die Schutzplatte und die Sensorplatte sich hinter dem Stoßdämpfungsmaterial (15) des Stoßfängers befinden.

31. Fahrzeugstoßfänger nach einem der Ansprüche 25 bis 30, falls abhängig von Anspruch 15, wobei der zweite Sensor (20) am Stoßfänger angebracht ist.

32. Fahrzeug (10), das einen oder mehrere Sensoren nach einem der Ansprüche 1 bis 24 oder eine oder mehrere Fahrzeugstoßfänger nach einem der Ansprüche 25 bis 31 aufweist, die daran angebracht sind.

## Revendications

1. Capteur de proximité (1) pour un véhicule, comprenant:
une plaque de protection (3) située le plus à l'intérieur;
une plaque de capteur (2) généralement allongée située le plus à l'extérieur; et
un moyen de calcul permettant de fournir des informations de proximité basées sur la capacité entre la plaque de capteur et la masse électrique, **caractérisé par le fait que** la forme de la plaque de capteur varie sur sa longueur afin de fournir des parties ayant une sensibilité accrue.

2. Capteur selon la revendication 1, dans lequel la plaque de protection et la plaque de capteur sont proches l'une de l'autre.

3. Capteur selon la revendication 1 ou 2, dans lequel, pendant l'utilisation, la plaque de protection est disposée de manière à être située entre la plaque de capteur et le véhicule (10).

4. Capteur selon la revendication 1, 2 ou 3, dans lequel la plaque de capteur a une largeur non uniforme sur toute sa longueur.

5. Capteur selon l'une quelconque des revendications précédentes, dans lequel la plaque de capteur est pourvue, à chaque extrémité, d'une partie (4, 5) de largeur supérieure à la partie du milieu.

6. Capteur selon l'une quelconque des revendications précédentes, dans lequel la largeur de la plaque de capteur en un point donné de la longueur de la plaque de capteur est choisie en fonction de la forme et de l'orientation d'un pare-choc (6) sur lequel le capteur est destiné à être fixé pendant l'utilisation.

7. Capteur selon l'une quelconque des revendications précédentes, dans lequel la partie centrale de la plaque de capteur a une largeur essentiellement uniforme et est pourvue de parties d'extrémité (4, 5) comportant au moins une partie de largeur supérieure.

8. Capteur selon la revendication 7, dans lequel la largeur des parties d'extrémité (5) de la plaque de capteur augmente progressivement vers les extrémités.

9. Capteur selon la revendication 7, dans lequel la largeur des parties d'extrémité (4) est uniforme.

10. Capteur selon la revendication 7, dans lequel les parties d'extrémité comprennent une première partie (4) de largeur supérieure à la partie du milieu et une seconde partie (4b), la plus extérieure, de largeur inférieure à la première partie.

11. Capteur selon l'une quelconque des revendications précédentes, dans lequel la plaque de protection est une bande allongée.

12. Capteur selon la revendication 10, dans lequel la plaque de protection a une largeur plus grande aux extrémités.

13. Capteur selon l'une quelconque des revendications précédentes, dans lequel la largeur de la plaque de protection en un point donné est sélectionnée en fonction de la forme et de l'orientation du pare-choc sur lequel elle est destinée à être fixée pendant l'utilisation.

14. Capteur selon l'une quelconque des revendications précédentes, dans lequel le moyen de calcul détermine les informations de proximité sur la base de la vitesse du véhicule, de la capacité déterminée et de la vitesse de variation de la capacité déterminée.

15. Capteur selon l'une quelconque des revendications précédentes, comprenant, en outre, un second capteur (20) servant à fournir un signal de compensation représentatif de la hauteur du capteur au-dessus du sol et dans lequel le moyen de calcul est adapté pour corriger les informations de proximité en utilisant le signal de compensation.

16. Capteur selon la revendication 15, dans lequel le second capteur (20) est un capteur capacitif.

17. Capteur selon les revendications 15 ou 16, dans lequel le second capteur (20) est agencé pour détecter la hauteur du capteur au-dessus du sol à l'extérieur du véhicule.

18. Capteur selon l'une quelconque des revendications précédentes, comprenant, en outre, une plaque de blindage (7).

19. Capteur selon la revendication 18, dans lequel la plaque de blindage (7) est connectée à la plaque de protection (2).

20. Capteur selon la revendication 18, dans lequel la plaque de blindage (2) est connectée à la masse électrique.

21. Capteur selon la revendication 19 ou 20, dans lequel la plaque de blindage (7) est connectée de manière capacitive.

22. Capteur selon l'une quelconque des revendications 18 à 21, dans lequel la plaque de blindage est disposée sous la plaque de capteur.

23. Capteur selon l'une quelconque des revendications 18 à 22, dans lequel la plaque de blindage est formée en tant que revêtement électroconducteur sur la surface d'un objet sur lequel le capteur est fixé.

24. Capteur selon la revendication 23, dans lequel le revêtement conducteur est une peinture.

25. Pare-choc (6) de véhicule pourvu d'un capteur (1) fixé dur celui-ci selon l'une quelconque des revendications précédentes.

26. Pare-choc de véhicule selon la revendication 25, dans lequel la plaque de protection (3) et la plaque de capteur (2) sont montées, pendant l'utilisation, sur le côté le plus intérieur du pare-choc.

27. Pare-choc de véhicule selon les revendications 25 ou 26, dans lequel la plaque de protection et la plaque de capteur s'étendent essentiellement sur toute la longueur du pare-choc.

28. Pare-choc de véhicule selon les revendications 25, 26 ou 27, dans lequel la plaque de capteur possède, sur sa longueur, une ou plusieurs partie/s (4, 5) de plus grande largeur correspondant à des obstacles sur le pare-choc à l'extérieur de la plaque de capteur. dans

29. Pare-choc de véhicule selon l'une quelconque des revendications 25 à 28, dans lequel la plaque de protection et la plaque de capteur sont enfermées, au moins partiellement, dans le matériau amortisseur de chocs (15) du pare-choc.

30. Pare-choc de véhicule selon l'une quelconque des revendications 25 à 28, dans lequel la plaque de protection et la plaque de capteur sont situées derrière le matériau amortisseur de chocs (15) du pare-choc.

31. Pare-choc de véhicule selon l'une quelconque des revendications 25 à 30 lorsqu'elle est dépendante de la revendication 15, dans lequel le second capteur (20) est monté sur le pare-choc.

32. Véhicule (10) pourvu d'un ou plusieurs capteur/s selon l'une quelconque des revendications 1 à 24 ou d'un ou plusieurs pare-choc/s selon l'une quelconque des revendications 25 à 31 fixé(s) sur celui-ci.
